# EUROPEAN PATENT APPLICATION

(11) **EP 2 515 331 A1**
(43) Date of publication of application: **24.10.2012**
(21) Application number: 12164767.1
(22) Date of filing: 19.04.2012
(51) Int. Cl.: H01L 23/34, H02P 1/00, H05K 7/20

(54) **Engine start control apparatus**

(30) Priority: 22.04.2011 JP 2011095639
(71) Applicant: Hitachi Automotive Systems, Ltd., Hitachinaka-shi Ibaraki 312-8503 (JP)
(72) Inventor: Saito, Masato, Ibaraki, 312-8503 (JP); Abe, Hiroyuki, Ibaraki, 312-8503 (JP); Uchiyama, Kaoru, Ibaraki, 312-8503 (JP); Omata, Shigehiko, Ibaraki, 312-8503 (JP)
(74) Representative: MERH-IP Matias Erny Reichl Hoffmann

(57) **Abstract**

The accuracy of measuring the temperature of a semiconductor element is improved, while a method for measuring the temperature using a general-purpose semiconductor element is provided at low cost. A fourth conductor 234 that is a part of a first conductor 231 connected to a power semiconductor element and is a thin line pattern extends under a chip thermometer 4. The fourth conductor 234 and the thermometer 4 are connected to each other through high thermal conductive resin.

## Description

### BACKGROUND OF THE INVENTION

### 1. Field of the Invention

The present invention relates to a structure of an engine start control apparatus.

### 2. Description of the Related Art

Large currents flow through some semiconducting devices. In such a semiconducting device, conventionally, the temperature applied on an electronic component may exceed an upper temperature limit since heat is generated in a power semiconductor element or a conductive wiring by the flow of the large current. If the power semiconductor element fails to operate due to the temperature, a voltage surge or another factor, a short current flows in the power semiconductor element and thus the temperature of the semiconductor element will further increase.

Therefore, the conventional semiconducting device has been designed for safety by adopting some procedures such as monitoring the temperature of the semiconductor element and accordingly, the current flow is adjusted or stopped.

Since a chip part of the power semiconductor element is dominant as a heat generating source in the semiconducting device, an increase in the temperature of the chip part is largest; nonetheless, it is difficult to directly measure the temperature of the chip part of the power semiconductor element. When the temperature of a substrate part other than the chip part of the semiconductor element is to be measured, the accuracy of measuring the temperature is significantly reduced if a thermal resistance between the chip part and a position at which the temperature of the substrate part is measured is large.

Accordingly, it is requested to reduce the thermal resistance between the chip part and the position at which the temperature is measured and to improve the accuracy of measuring the temperature. The following has been proposed as a method that solved those problems.

JP-2007-049810-A discloses that the temperature of a thermal diffusion conductor is measured, the thermal diffusion conductor is bonded using brazing filler metal and disposed on the side of an upper surface of a bare-chip of the power semiconductor element, thereby improving the accuracy of measuring the temperature.

### SUMMARY OF THE INVENTION

For example, a semiconducting device in which a large current flows and thus it is necessary to be protected from an increase in a temperature is a power switch module for an idling stop starter. When the starter starts an engine, a large current of several hundred amperes flows in the starter. A MOSFET that is mounted in the power switch module controls switching of a current to be supplied to a starter motor. In this case, the chip of the MOSFET is a heat generating source. The chip junction temperature, therefore, may exceed a guaranteed temperature ranging from 150°C to 175°C, and it is feared that a malfunction may be incurred.

Moreover, with the idling stop starter, the time it takes to start the engine is a period of time as short as approximately 0.2 to 1 second. This makes the time for a current to start to flow in the power switch module be short as well. Therefore, responsively measuring an increase in temperature of the MOSFET chip caused by the flow of the current is required so as to adjust or block the current at an appropriate time.

Although the accuracy of measuring the temperature can be enhanced by the technique described in JP-2007-049810-A and the like, the structure described in the document, however, is very expensive and can be applied to only a structure in which the bare-chip is mounted. In structure, a chip thermistor and chip diode for general-purposes, which are mounted on a normal substrate and used as a thermometer, cannot conduct temperature measurement.

A thermocouple, representing a general thermometer, is necessary to be attached to a measuring unit and to arrange the wiring therefor, after parts are mounted on a substrate. Thus, there are disadvantages that the usability is deteriorated and the number of assembling processes is increased. The chip thermistor, the chip diode and the like, on the other hand, can be simultaneously mounted as another electronic part is mounted on the surface of the substrate, and this can reduce the number of assembling processes. Accordingly, it is possible to inexpensively assemble the parts and conduct product assembly suitable for mass-production.

It is preferable to use a general-purpose chip thermometer, a general-purpose electronic part and a substrate in order to form an inexpensive structure and measure a temperature as a method for measuring the temperature.

An object of the present invention is to improve the accuracy of measuring the temperature of a power semiconductor using a general-purpose chip thermometer or the like.

The aforementioned object is accomplished by an engine start control apparatus in which a temperature detecting element has at least two connection parts that are electrically connected to conductive wirings, respectively, and a part of a conductive pattern that is connected to a power semiconductor element extends between the connecting parts.

According to the present invention, since a conductor on which the power semiconductor element is mounted is directly connected to a chip thermometer through a high thermal conductive member, a thermal resistance between a chip of the power semiconductor element and the temperature detecting element can be made low. It is, therefore, possible to measure an increase in the temperature of the chip with high accuracy.

### BRIEF DESCRIPTION OF THE DRAWINGS

Fig. 1 is a diagram illustrating a first embodiment of the present invention.
Fig. 2 is a cross-sectional view of a section in which a thermometer is mounted according to the first embodiment of the present invention.
Fig. 3 is a cross-sectional view of a MOSFET according to the first embodiment of the present invention.
Fig. 4 is an assembly diagram illustrating a mold case according to the first embodiment of the present invention.
Fig. 5 is a diagram illustrating a second embodiment of the present invention.
Fig. 6 is a diagram illustrating a third embodiment of the present invention.
Fig. 7 is a diagram illustrating a resist-coated structure according to the present invention.
Fig. 8 is a cross-sectional view of a section in which the thermometer is mounted in the resist-coated structure according to the present invention.
Fig. 9 is a diagram illustrating a resist structure according to the present invention.
Fig. 10 is a diagram illustrating a fourth embodiment of the present invention.
Fig. 11 is a diagram illustrating another embodiment in which the present invention is applied to an idling stop starter.

### DESCRIPTION OF THE PREFERRED EMBODIMENTS

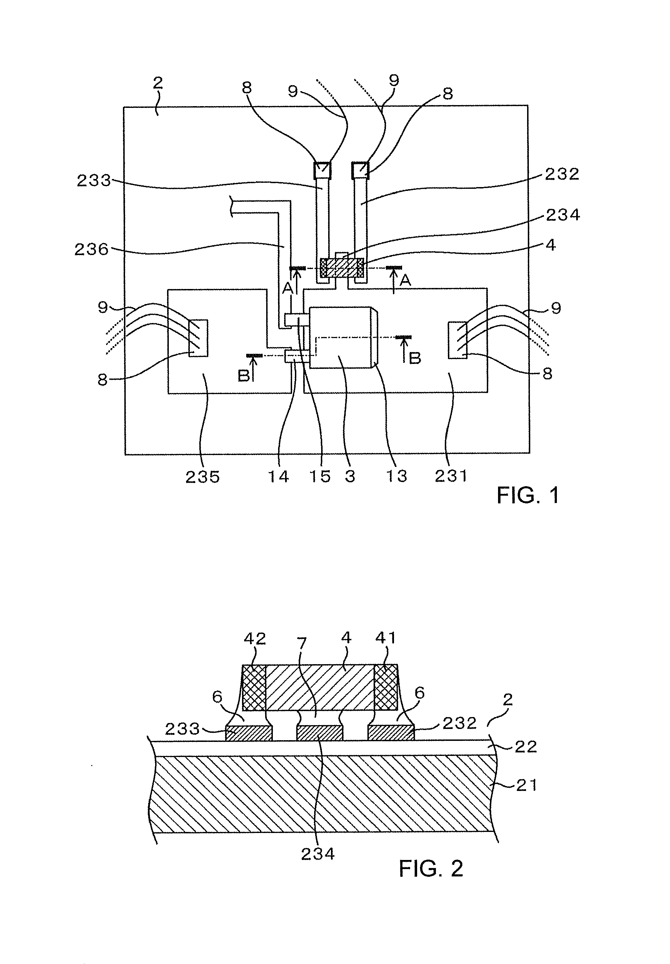

Figs. 1 and 2 illustrate a first embodiment of the present invention. Fig. 1 illustrates the first embodiment of the present invention, while Fig. 2 is a cross sectional view taken along line A-A of Fig. 1. Hereinafter, embodiments each describe a semiconducting device that includes a metal oxide semiconductor field effect transistor (MOSFET). The MOSFET is represented by a power switch module for an idling stop starter that is an in-vehicle device. Other semiconductor elements (such as an insulated gate bipolar transistor (IGBT), a power transistor and a power diode) in which heat is generated can be applied to the embodiments.

The embodiments describe the case in which a general-purpose inexpensive packaged MOSFET is used. A semiconducting device that has a bare-chip mounted therein can be applied to the present invention.

In Figs. 1 and 2, a substrate 2 has, as a base material, a metal base 21 which is made of aluminum, copper or the like. An insulating layer 22 that is made of epoxy resin is formed on the metal base 21. A circuit that includes a conductive wiring made of copper is formed on the insulating layer 22. A MOSFET 3, a thermometer 4, electrode pads 8 and another electronic part (not illustrated) are electrically connected to each other through solder 6 on upper surfaces of conductors. The thermometer 4 includes a chip thermistor, a chip diode and the like. The electrode pads 8 are made of aluminum, nickel or the like.

Of the conductive wirings, a heat spreader 13 that is a drain terminal of the MOSFET 3 is electrically connected to a first conductor 231, a source terminal 14 of the MOSFET 3 is electrically connected to a fifth conductor 235, a gate terminal 15 controls a conduction of the MOSFET 3 is electrically connected to a sixth conductor 236. The electrode pads 8 are mounted on the first and fifth conductors 231 and 235 through the solder 6. A plurality of wires 9 that are made of aluminum, copper or the like are bonded to the electrode pads 8. The wires 9 are connected to current-voltage input/output terminals of an external device.

Temperature signal terminals 41 and 42 of the thermometer 4 are electrically connected to second and third conductors 232 and 233, respectively. The electrode pads 8 are mounted on the second and third conductors 232 and 233 by soldering. Wires 9 that are made of aluminum, copper or the like are bonded to the electrode pads 8. A signal of a temperature sensed by the thermometer 4 is output to an external engine control unit (ECU).

A fourth conductor 234 that is a part of the first conductor 231 and is a thin line protrudes from the first conductor 231 and extends between the second conductor 232 and the third conductor 233 under the thermometer 4. The fourth conductor 234 and the thermometer 4 are bonded to each other through high thermal conductive resin 7 such as an Ag paste.

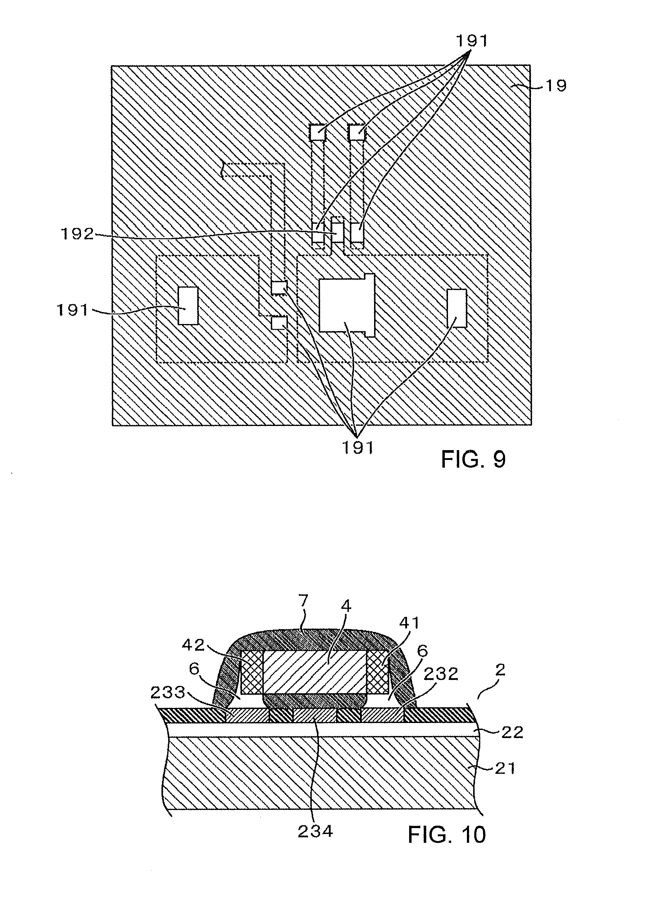

When a high thermal conductive resin has an insulation property is used for the high thermal conductive resin 7, the high thermal conductive resin 7 may be subjected to potting so that the high thermal conductive resin 7 covers an entire electrode part of the thermometer 4. The potted high thermal conductive resin 7 may be filled between the thermometer 4 and the fourth conductor 234, and is connected to the thermometer 4 and the fourth conductor 234, as shown in Fig. 10.

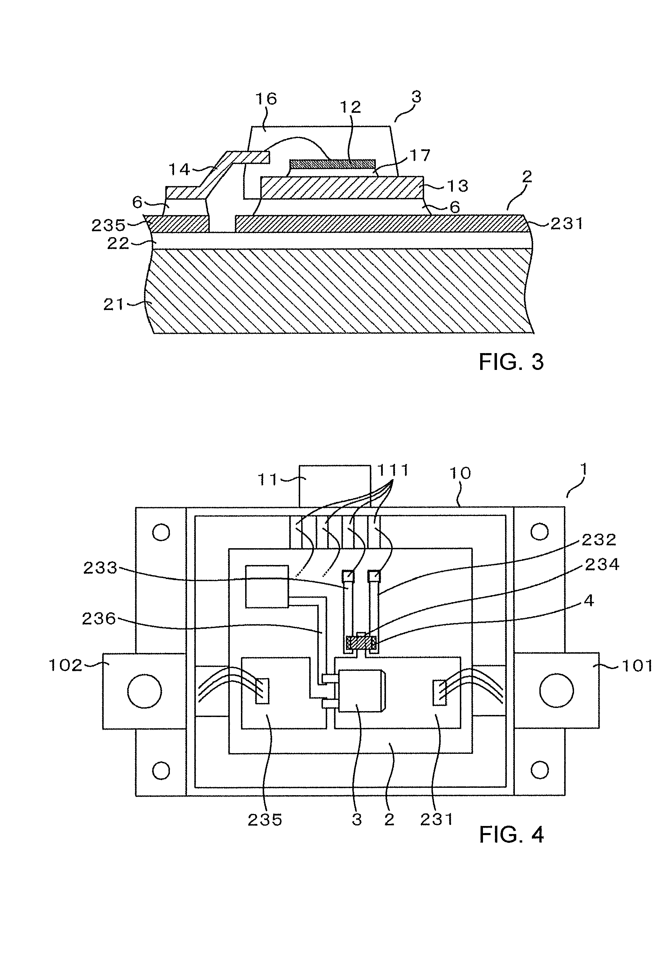

Next, the configuration of the MOSFET 3 is described. Fig. 3 is a cross-sectional view of the MOSFET 3. In the MOSFET 3, a silicon chip 12 is mounted on the copper-made heat spreader 13 through solder 17 for mounting the chip. An upper surface of the chip 12 is electrically connected to the copper-made source terminal 14 and the gate terminal 15 (illustrated in Fig. 1) by aluminum wire bonding. The chip 12, the heat spreader 13, the source terminal 14 and the gate terminal 15 are sealed and packaged by epoxy resin.

The MOSFET 3 is connected to the copper-made first conductor 231 and bonded to the thermometer 4 with the high thermal conductive resin 7 through the fourth conductor 234 that is the part of the first conductor 231. Since a part that extends between the chip 12 and the thermometer 4 can be made of a high thermal conductive member with a thermal conductivity of approximately 3 to 400 W/mK, a thermal resistance between the chip 12 and the thermometer 4 can be small.

If a thermometer is mounted on a conductor that is included in a circuit different from a conductor on which a power semiconductor element (IGBT) is mounted like a conventional inverter or the like, a space located between the conductors is filled with a resist (epoxy) that has a thermal conductivity of approximately 0.2 W/mK. Thus, a thermal resistance on a heat transfer path is large and the accuracy of measuring a temperature is significantly reduced. Therefore, the accuracy of measuring the temperature can be improved by applying the present invention.

Fig. 4 is an assembly diagram illustrating a mold case 10. The mold case 10 houses the substrate 2. When the mold case 10 is used for an idling stop starter for a vehicle, the mold case 10 electrically and mechanically connects the external starter to the substrate 2. The mold case 2 is made of thermoplastic resin such as polyphenylene sulfide (PPS) or polybutylene terephthalate (PBT). The mold case 10 has therein an input-side busbar 101 and an output-side busbar 102. The busbars 101 and 102 are made of copper and formed by insert molding. The busbars 101 and 102 are used to electrically connect the starter to the substrate 2.

The mold case 10 is fixed to the substrate 2 using a silicon adhesive (not illustrated). The input-side busbar 101, the output-side busbar 102 and a connector terminal 111 are bonded to the electrode pads 8 of the substrate 2 through the wires 9 made of aluminum, copper or the like and electrically connected to the external starter so that a current flowing on the substrate 2 and a voltage signal are transferred between the substrate 2 and the starter. A voltage signal of a temperature that is measured by the thermometer 4 is transmitted to the external ECU through a connector 11 and the connector terminal 111 that is formed with the mold case 10 by integral molding.

It is known that aluminum wires are used as the wires used for bonding from a viewpoint of the cost, handling and reliability. The electrode pads 8 are pads that are provided for the bonding and necessary for aluminum wire bonding on the side of the substrate 2. The connections of the busbars to the electrode pads 8 may be achieved by aluminum ribbon bonding.

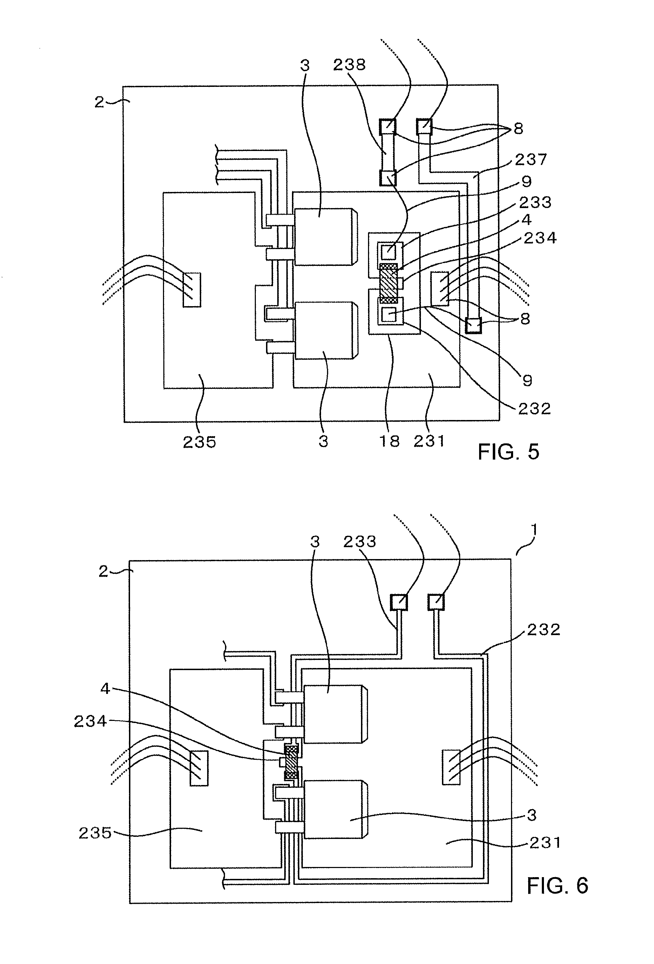

Fig. 5 illustrates a second embodiment of the present invention. If the embodiment of the present invention is applied to an idling stop starter for a vehicle, the MOSFET controls switching of a current of several hundred amperes. Therefore when the single MOSFET is used and the value of a current exceeds an acceptable current value, two or more MOSFETs are generally mounted and used as illustrated in Fig. 5.

In this case, when thermometers 4 are arranged for the MOSFETs, respectively, the temperatures of the MOSFETs can be accurately detected. When a space in which the parts are mounted and a reduction in the number of the parts are considered, it is preferable that the single thermometer detect the temperatures of the plurality of MOSFETs with the same accuracy.

In Fig. 5, the two MOSFETs 3 are connected in parallel and mounted on the first conductor 231. A conductor opening 18 is located between the MOSFETs 3 and the electrode pad 8 that is used to input a current and mounted on the first conductor 231. The thermometer 4 is mounted on the second conductor 232 and the third conductor 233, while the second conductor 232 and the third conductor 233 are arranged in the conductor opening 18. The fourth conductor 234 protrudes from the first conductor 231 toward the inner side of the conductor opening 18 and extends between the second conductor 232 and the third conductor 233 under the thermometer 4. The fourth conductor 234 and the thermometer 4 are connected to each other through the high thermal conductive resin 7.

A seventh conductor 237 and an eighth conductor 238 are arranged by the first conductor 231 and serve as wirings for outputting a temperature signal detected by the thermometer 4 to the outside. Since the second and third conductors 232 and 233 located in the conductor opening 18, and the seventh and eighth conductors 237 and 238 are connected to each other by aluminum wires, the detected temperature signal can be output to the outside.

The single thermometer 4 is arranged so that a thermal resistance between a chip of one of the two MOSFETs 3 arranged in parallel and the thermometer 4 and a thermal resistance between a chip of the other MOSFET 3 and the thermometer 4 are equal to each other. Thus, the single thermometer 4 can detect the temperatures of the two MOSFETs 3 with the same accuracy. The present embodiment describes that the two MOSFETs are used. However, when three or more MOSFETs 3 are used, and the single thermometer 4 is arranged so that thermal resistances between the thermometer 4 and chips of the MOSFETs 3 are equal to each other, the thermometer 4 can detect the temperatures of the MOSFETs 3 with the same accuracy.

The thermal resistances between the thermometer 4 and the chips of the MOSFETs 3 are determined on the basis of a conductivity, a mounting area, a thickness and a distance, which are associated with the chip and the thermometer 4,the constituents including chip 12, the solder 17 (for mounting the chip 12), the heat spreader 13, the solder 6 (on which the heat spreader 13 is mounted), the first conductor 231, the fourth conductor 234, the thermal conductivity of the high thermal conductive resin 7.

Fig. 6 illustrates a third embodiment of the present invention. In the second embodiment illustrated in Fig. 5, the thermometer 4 is arranged so that the thermal resistances between the thermometer 4 and the MOSFETs 3 are equal to each other, the conductor opening 18 is located in a central part of the first conductor 231, and the signal is transmitted to the outside through the wire 9. Thus, the structure illustrated in Fig. 5 is complex. A structure that is formed by improving the structure illustrated in Fig. 5 is described in the third embodiment.

In the structure illustrated in Fig. 6, the thermometer 4 is arranged between the first conductor 231 and the fifth conductor 235. The second conductor 232 and the third conductor 233 also extend to a space located between the first conductor 231 and the fifth conductor 235. Two MOSFETs 3 are connected to the first conductor 231 in parallel. The second conductor 232 and the third conductor 233 are connected to electrodes of the thermometer 4. The fourth conductor 234 protrudes from the first conductor 231 and extends through a space located between the second conductor 232 and the third conductor 233 under the thermometer 4. The fourth conductor 234 and the thermometer 4 are connected to each other through the high thermal conductive resin 7. In the present embodiment, the single thermometer 4 is arranged so that thermal resistances between the thermometer 4 and the chips of MOSFETs are equal to each other.

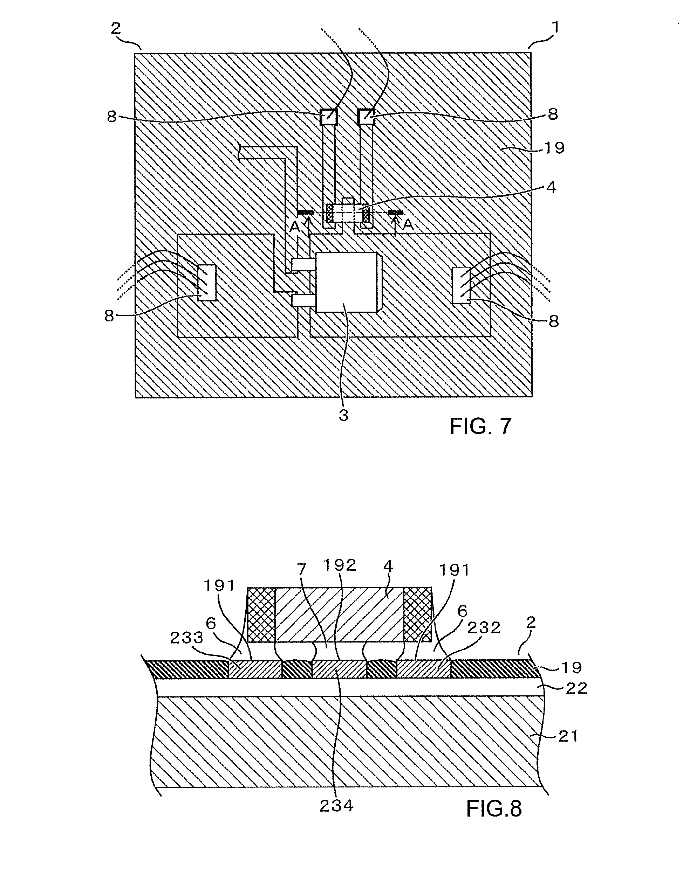

Figs. 7 to 9 illustrate a resist-coated structure according to the present invention. Conventionally, a resist that is made of thermosetting epoxy is coated in order to mount parts on a substrate and insulate and protect a conductor. In addition, the resist has an opening that corresponds to a part mounting section of the conductor and causes the conductor and an electronic part to be electrically connected to each other on the part mounting section of the conductor. The conductor and the electronic part are connected to each other using the solder 6. The opening of the resist limits a range of soldering and is used to prevent a lack (caused by flow of the solder) of the solder and the like. Resists need to be coated on many substrates. In the present invention, the structure has a resist opening 191 (generally used and provided for an electrical connection) and a resist opening 192 that is not provided for an electrical connection and is provided for a direct measurement of the temperature of a conductor.

In the embodiment illustrated in Figs. 7 and 8, the thermometer 4 can measure the temperature of the conductor exposed by the resist opening 192 through the high thermal conductive resin 7. Thus, the thermometer 4 can measure the temperature of the conductor without a resist with a poor thermal conductivity (of approximately 0.2 W/mK). The accuracy of measuring the temperature can be significantly improved. As the thermometer 4 for measuring the temperature of the conductor, the thermometer that is a chip type electronic part is proposed above. A read type thermometer or a thermocouple, however, may be used as the thermometer as well.

Next, an attachment structure that is used when the semiconducting device according to the present invention is used for an idling stop starter for a vehicle will be described.

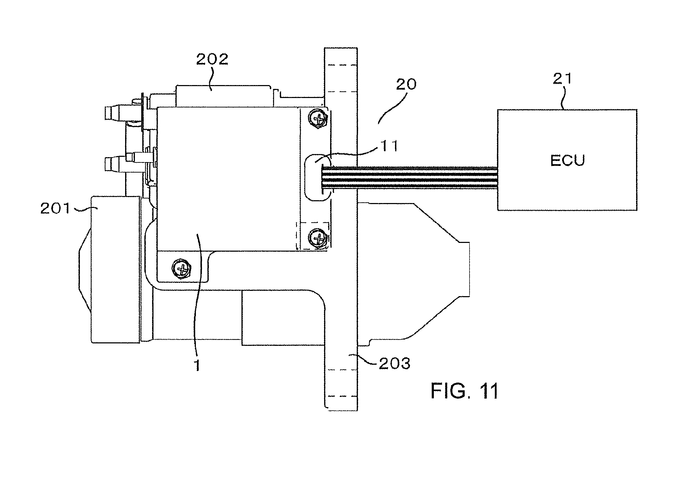

Fig. 11 illustrates the appearance of the structure in which the semiconducting device according to the present invention is attached to the idling stop starter in an integrated manner. The idling stop starter 20 includes a starter motor 201, a magnetic switch 202 and a gear case 203. The starter motor 201 rotates a pinion gear (not illustrated) engaged with an engine (not illustrated) and thereby rotates the engine. The magnetic switch 202 pushes the pinion gear of the idling stop starter 20 to the engine and thereby engages the pinion gear with the engine. The gear case 203 holds the semiconducting device 1 according to the present invention, the starter motor 201 and the magnetic switch 202 and is used to attach the engine of the idling stop starter 20. The semiconducting device 1 receives an idling stop instruction signal from an ECU 21. Then, the semiconducting device 1 switches the MOSFET included in the semiconducting device 1 and thereby controls currents that will flow to the starter motor 201 and the magnetic switch 202. The semiconducting device 1 is used for a vehicle to perform idling stop. The semiconducting device 1 and the ECU 21 are connected to each other through the connector 11. The semiconducting device 1 transmits a signal of a temperature measured and detected by the thermometer 4 to the ECU 21 through the connector 11. When the value of the temperature signal is equal to or higher than a predetermined value, the semiconducting device 1 controls the currents (that will flow to the starter motor 201 and the magnetic switch 202), blocks the currents, and the like.

Features, components and specific details of the structures of the above-described embodiments may be exchanged or combined to form further embodiments optimized for the respective application. As far as those modifications are apparent for an expert skilled in the art they shall be disclosed implicitly by the above description without specifying explicitly every possible combination.

## Claims

1. A control device comprising:
a power semiconductor element;
a temperature detecting element; and
a circuit substrate (2) that has a plurality of conductive wirings,
wherein the power semiconductor element and the temperature detecting element are mounted on the circuit substrate (2),
wherein the temperature detecting element has at least two connection parts that are electrically connected to the conductive wirings, respectively, and
wherein a part of a conductive pattern that is connected to the power semiconductor element extends between the connection parts.

2. The control device according to claim 1,
wherein the part of the conductive pattern and a nonconnection part of the temperature detecting element are connected to each other through a thermal conductive member.

3. The control device according to claim 2,
wherein when a temperature that is detected by the temperature detecting element is equal to or higher than a predetermined temperature, an operation of the power semiconductor element is limited or stopped.

4. The control device according to claim 1, further comprising
a covering member that covers the conductive wirings and has an opening that causes the part of the conductive pattern to be exposed.

5. The control device according to claim 1,
wherein the plurality of power semiconductor elements are arranged, and
wherein the temperature detecting element is so arranged that thermal resistances between the thermometer (4) and the power semiconductor elements are equal to each other.

6. The control device according to any of claims 1 to 5,
wherein the temperature detecting element has the connection parts at both ends of the temperature detecting element and is a chip type electronic part mounted on the conductive wirings.

7. An engine start control apparatus comprising:
a motor:
a gear;
a switch that connects the motor to an engine through the gear; and
a control device according to at least one of claims 1 to 6,
wherein the power semiconductor element controls the switch and/or a current to be provided to the motor and starts the engine.

8. The engine start control apparatus according to claim 7,
wherein a thermal conductivity of the thermal conductive member is 3 W/mK or higher.

9. The engine start control apparatus according to any of claims 7 or 8,
wherein the power semiconductor element or each of the power semiconductor elements has a MOSFET (3).

10. The engine start control apparatus according to claim 7,
wherein the temperature detecting element outputs information on a temperature detected by the temperature detecting element to an engine control unit for the engine, and
wherein when the engine control unit determines that the detected temperature is equal to or higher than a predetermined temperature, an operation of the power semiconductor element is limited or stopped on the basis of a signal output from the engine control unit.

11. The engine start control apparatus according to claim 10,
wherein idling stop is performed on the basis of the signal output from the engine control unit.
